# EUROPÄISCHE PATENTSCHRIFT

(11) **EP 0 691 069 B1**
(45) Veröffentlichungstag und Bekanntmachung des Hinweises auf die Patenterteilung: **11.12.1996**
(21) Anmeldenummer: 94906859.7
(22) Anmeldetag: 10.02.1994
(51) Int. Cl.: H05K 7/14

(54) **VERBINDUNGSRÜCKWAND FÜR BAUGRUPPENTRÄGER**
CONNECTING REAR WALL FOR SUB-RACKS
PANNEAU ARRIERE DE CONNEXION POUR CHASSIS EQUIPES

(30) Priorität: 22.03.1993 DE 4309172
(43) Veröffentlichungstag der Anmeldung: 10.01.1996
(73) Patentinhaber: Siemens Nixdorf Informationssysteme AG, 33106 Paderborn (DE)
(72) Erfinder: KNOOP, Franz-Josef, D-33142 Büren-Steinhausen (DE); GOCKEL, Ludger, D-33100 Paderborn (DE)
(74) Vertreter: Fuchs, Franz-Josef, Dr.-Ing.
(86) Internationale Anmeldenummer: DE9400138
(87) Internationale Veröffentlichungsnummer: WO9422283

(56) Entgegenhaltungen:
- EP-A- 0 236 799
- EP-A- 0 311 706
- US-A- 3 992 686
- US-A- 5 023 754

## Beschreibung

Die Erfindung betrifft eine Verbindungsrückwand mit auf einer Verbindungsplatine angeordneten Steckvorrichtungen für die Kontaktierung elektronischer und/oder elektromechanischer Einschubbaugruppen in Baugruppenträgern untereinander und mit den Potentialleitungen wenigstens einer Spannungsversorgungseinrichtung.

In Einschubtechnik aufgebaute Baugruppen, die in einem Baugruppenträger miteinander betrieben werden, sind insbesondere bei Geräten der Datentechnik allgemein gebräuchlich. An diese Geräte werden hohe Anforderungen hinsichtlich der Unterdrückung hochfrequenter Störstrahlung gestellt. Da die Entstehung solcher Störungen auf den Baugruppen unvermeidbar ist, werden diese und/oder der Baugruppenträger allgemein als Abschirmkäfige ausgeführt.

Ein Problem stellt dabei die Verbindungsrückwand dar, die zum einen die Rückseite des Baugruppenträgers offen läßt und zum anderen als Sendeantennen für die Störstrahlung wirkende Verbindungsleitungen trägt. Ihre Abschirmung wird insbesondere bei Baugruppenträgern schwierig, in die von zwei gegenüberliegenden Seiten Baugruppen einschiebbar sind, bei denen die Verbindungsrückwand also in der Mitte des Baugruppenträgers liegt. Ein solcher Baugruppenträger ist beispielsweise aus der DE 36 08 046 A1 bekannt. Es ist bereits aus der US 3 992 686 bekannt, die Verbindungsrückwand als mehrlagige gedruckte Schaltungsplatine auszubilden und dabei eine Lage zur Führung des Nullpotentials und damit als großflächigen Hochfrequenzschirm (ground plane) zu benutzen. Eine weitere Lage führt eine Versorgungsspannung.

Nachteilig dabei ist, daß der Schirm eine geringe Querschnittsfläche hat, im allgemeinen also - obwohl meist auf Nullpotential liegend - nur bedingt als stromführender Leiter für die Spannungsversorgung geeignet ist. Gleiches gilt für die die Versorgungsspannung führende Lage. Zur Stromführung werden deshalb zusätzlich Leiter größeren Querschnitts benutzt. Diese bilden aber hochfrequenztechnisch oft nur schwer zu beherrschende Potentialschleifen mit dem Schirm.

Es ist Aufgabe der Erfindung, eine Verbindungsrückwand der eingangs genannten Art anzugeben, die eine verbesserte Schirmwirkung gegen hochfrequente Störstrahlung aufweist und zwecks leichter Recyclierbarkeit einfach zu zerlegen ist.

Diese Aufgabe wird durch die im kennzeichnenden Teil des Anspruchs 1 angegebenen Merkmale gelöst.

Die Metallplatten dienen dabei zugleich als Schirm und als jeweils einziger Leiter für die Versorgungsströme und deren Rückführung. Da sie mit einem im Vergleich zu gedruckten Leiterbahnen beachtlichen Querschnitt ausgestattet sein können - Plattendicken im mm-Bereich sind leicht realisierbar - erfolgt die Stromleitung mit minimalem Widerstand und geringer Induktivität. Eine sehr schnelle Ableitung impulsförmiger Störströme ist also gegeben, so daß sich hohe Impulsspannungen nicht aufbauen können. Dadurch sind auch steile Impulsflanken möglich, wodurch die Grenzfrequenz des Systems erhöht wird.

Die jeweiligen Potentiale werden über Verbindungselemente großen Querschnitts auf Kontaktflächen auf der Verbindungsplatine und von dort auf die Kontakte der benachbarten Steckvorrichtungen geführt. Diese Anordnung stellt ebenfalls eine Verbindung mit niedrigem Widerstand und geringer Induktivität dar. Im Sinne einer vorteilhaften Doppelwirkung dienen die Verbindungselemente zugleich der Befestigung der Metallplatten an der Verbindungsplatine mit einem durch ihre Höhe vorgegebenen Abstand.

In Fortbildung der Erfindung sind die Verbindungselemente als freigestanzte Lappen einstückig an die Metallplatten angeformt. Ihre Funktion als Abstandshalter erhalten die Lappen durch Z-förmige Abkröpfung.

In die im zusammengebauten Zustand an den Kontaktflächen anliegenden Flächen der Verbindungselemente sind Befestigungslöcher eingebracht. Bei Verwendung der oben genannten Lappen als Verbindungselemente werden vorzugsweise zugleich mit dem Freistanzgang Löcher mit Durchzügen eingeformt, die mit im Kontaktflächenbereich angeordneten Löchern in der Verbindungsplatine fluchten. Selbstfurchende Schrauben werden durch diese Löcher hindurch in die Befestigungslöcher geschraubt. Die Verschraubung bewirkt eine Preßverschweißung zwischen den Metallen der Kontaktflächen und der Befestigungselemente und damit eine gasdichte, korrosionsbeständige Verbindung zwischen beiden.

Vorzugsweise ist die der Verbindungsplatine nähere Metallplatte kleiner als die jeweils benachbarte weiter entfernte. Damit werden diese zwischen der Verbindungsplatine und der äußersten, Massepotential führenden Metallplatte eingeschlossen. Dies hat die Vorteile, daß den innen liegenden Platten aus entstörtechnischer Sicht weniger Aufmerksamkeit geschenkt werden muß, und daß Verbindungen zwischen den einzelnen Platten und der Verbindungsplatine einander nicht kreuzen.

Dies ist aber nur so lang möglich, als nur eine Verbindungsplatine verwendet wird. Bei dem oben erwähnten doppelseitigen Baugruppenträger soll, um die Vorteile der vorliegenden Erfindung zu nutzen, die Verbindungsrückwand mit zwei auf ihren Außenseiten liegenden Verbindungsplatinen ausgestattet sein.

Werden beide Verbindungsplatinen von den selben Metallplatten aus mit Spannungen versorgt, erhöht sich deren Zahl nicht.

Beide Verbindungsplatinen werden dabei vorzugsweise in der oben für eine Verbindungsplatine beschriebenen Weise mit den Metallplatten verbunden, daß heißt sie sind über Verbindungselemente mit diesen verschraubt. Dazu ist bei Verwendung Z-förmig gekröpfter Lappen jeweils ein Teil von diesen zur einen und zur anderen Verbindungsplatine hin abgebogen.

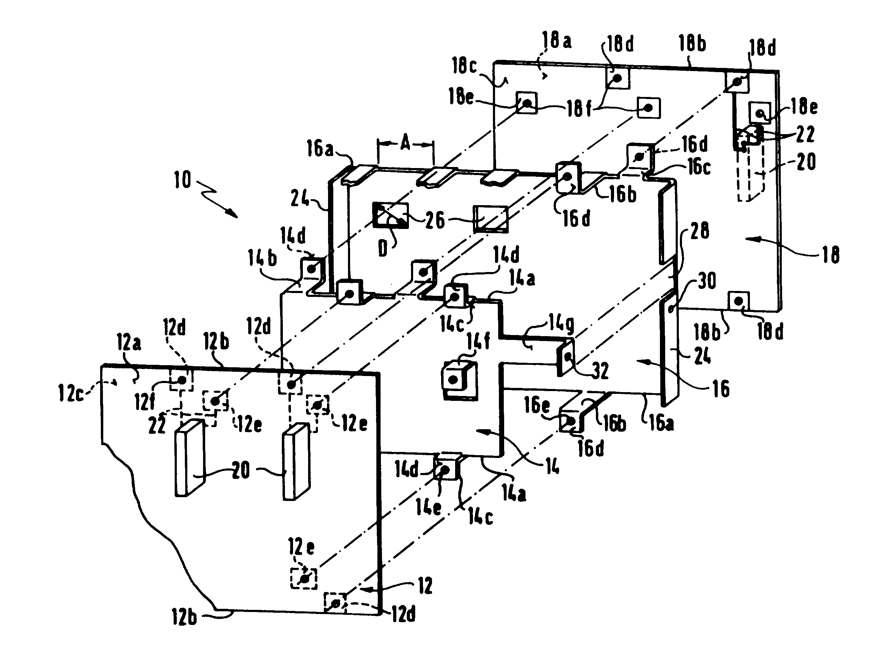

Weitere Merkmale und Vorteile der Erfindung ergeben sich aus der folgenden Beschreibung, welche in Verbindung mit der Zeichnung die Erfindung anhand eines Ausführungsbeispiels erläutert.

Die Figur zeigt eine schematische perspektivische Explosionsdarstellung einer Verbindungsrückwand.

Die in der Figur dargestellte, allgemein mit 10 bezeichnete Verbindungsrückwand umfaßt eine erste Verbindungsplatine 12, eine erste Metallplatte 14, eine zweite Metallplatte 16 und eine zweite Verbindungsplatine 18. Die Zahl der Metallplatten entspricht der Zahl unterschiedlicher Versorgungsspannungs-Pontentiale. Bei mehr als einer Versorgungsspannung erhöht sich die Zahl der Metallplatten. Die Verbindungsplatinen sind mehrlagige gedruckte Leiterplatten. Auf den von einander wegweisenden Außenflächen 12a und 18a der Verbindungsplatinen 12 bzw. 18 ist jeweils eine der Zahl der zu kontaktierenden Einschubbaugruppen (nicht dargestellt) entsprechende Anzahl von Steckvorrichtungen 20 angeordnet, von denen der Übersichtlichkeit halber nur einige dargestellt sind. An den Längskanten 12b, 18b der Verbindungsplatinen 12 bzw. 18 entlang sind auf deren einander zugewandten Innenflächen 12c, 18c Kontaktflächen 12d bzw. 18d als gedruckte Leiterflächen aufgebracht, die dem Anschluß der Masseverbindung dienen. Weitere Kontaktflächen 12e, 18e, die gegenüber den erstgenannten von den Längskanten 12b bzw. 18b weg in Richtung auf die Mitte der Verbindungsplatinen 12 bzw. 18 versetzt angeordnet sind, dienen dem Anschluß einer Versorgungsspannung. Die Kontaktflächen sind durch Leiterbahnen, wie dies bei 22 angedeutet ist, mit für die Spannungsversorgung vorgesehenen Kontakten der Steckvorrichtungen 20 verbunden. Im Kreuzungspunkt der Diagonalen durch die Kontaktflächen sind die Verbindungsplatinen 12, 18 mit Durchgangslöchern 12f, 18f versehen.

Die Metallplatten 14, 16 bestehen aus 1,5 mm dickem, verzinntem Kupferblech. An den Längskanten 14a, 16a der Metallplatten 14 bzw. 16 sind Lappen 14b, 14c bzw. 16b, 16c einstückig angeformt. Sie haben jeweils unterschiedliche Länge und sind Z-förmig abgekröpft: die langen Lappen 14b und die kurzen Lappen 16c in Richtung auf die zweite Verbindungsplatine 18; die kurzen Lappen 14c und die langen Lappen 16b in Richtung auf die erste Verbindungsplatine 12. Die Endflächen 14d, 16d der Lappen 14b, 14c, 16b, 16c sind mit Befestigungslöchern 14e, 16e versehen.

Randbereiche der Massepotential führenden zweiten Metallplatte 16, die keine Lappen tragen - im Ausführungsbeispiel sind dies die senkrechten Ränder 24 - sind in Richtung der Versorgungsspannung führenden ersten Metallplatte 14 aufgekantet. Dadurch ist letztere von der zweiten Metallplatte 16 im wesentlichen umschlossen.

Die Zuführung des Massepotentials zu der zweiten Metallplatte 16 erfolgt über eine an dem rechten Rand 24 anzubringende, nicht dargestellte Schraubverbindung. Lediglich ein Gewindeloch 30 ist in der Figur dargestellt. Die Zuführung des anderen Versorgungspctentials zu der ersten Metallplatte 14 erfolgt über eine einstückig an diese angeformte Anschlußfahne 14g, die ein Gewindeloch 32 trägt. Die Anschlußfahne 14g ragt durch eine Aussparung 28 im rechten Rand 24 hindurch. Die Zuführung kann über Kabel großen Querschnitts oder Stromschienen erfolgen.

Um die Hinführung der Lappen 14b zu der zweiten Verbindungsplatine 18 zu ermöglichen, sind in der zweiten Metallplatte 16 Durchbrüche 26 ausgestanzt. Deren Lage und Abmessungen sind so gewählt, daß die Endflächen 14d der Lappen 14b durch die Durchbrüche 26 hindurchtreten können, und daß die Lappen zu den Rändern der Durchbrüche einen für den Potentialunterschied zwischen beiden vorgeschriebenen Abstand nicht unterschreiten.

Es können Lappen nicht nur an den Rändern der Metallplatten ausgebildet werden. Ein Lappen 14f ist aus der Fläche der Metallplatte 14 durch Freistanzen auf drei Seiten und anschließendes Z-förmiges Abkröpfen gebildet. Dadurch werden Kontaktierungen zwischen Metallplatten und Verbindungsplatinen an jeder beliebigen Stelle möglich, was die Auslegung der Leitermuster auf den Verbindungsplatinen sehr erleichtert.

Die vorbeschriebene Ausgestaltung der Metallplatten gestattet deren wirtschaftliche Herstellung: Das Ausstanzen der Platten, das Freistanzen der Lappen und Stanzen der Befestigungslöcher, das Abkröpfen der Lappen und Aufkanten von Randbereichen kann in einem einzigen kombinierten Stanz-/Biegearbeitsgang erfolgen. Dabei können die Befestigungslöcher im Durchzugverfahren gebildet werden. Es formen sich dann, wie an sich für dieses Verfahren bekannt, auf der der jeweiligen Kontaktfläche 12d, 12e, 18d, 18e abgewandten Seite der Endflächen 14d, 16d trichterförmige Grate aus, die eine größere Zahl von Gewindegängen in den Befestigungslöchern 14e, 16e erlauben.

Um die gute Schirmwirkung der Massepotential führenden Metallplatte 16 nicht zu verschlechtern, sind das größte Lichtmaß der Durchbrüche 26, deren Diagonale D, und der Abstand A zwischen den Lappen 16b bzw. 16c bzw. zwischen den Lappen 16b und den aufgekanteten Rändern 24 so gewählt, daß diese 1/10 bis 1/20 der Wellenlänge des höchstfrequenten abzuschirmenden Signals nicht überschreiten. Im Ausführungsbeispiel sind dies 30 mm.

Zwischen den Metallplatten 14, 16 ist eine nicht dargestellte Isolierfolie eingefügt, die eine hohe Dielektrizitätskonstante aufweist. Auch ohne diese Folie, nur durch einen Luftspalt getrennt, bilden die Metallplatten die Belege eines Kondensators. Durch die Verwendung der vorgenannten Folie können diese noch näher zusammengebracht werden, wodurch die Kapazität steigt. Die gegenüber Luft höhere Dielektrizitätskonstante der Folie erhöht die Kapazität noch weiter.

Bei den vorherrschenden hohen Frequenzen der Störungen genügt die Kapazität zwischen den Metallplatten, um die auf den Versorgungsspannungen vagabundierenden Störungen nach Masse abzuleiten. Die Metallplatten stellen einen großflächigen Kondensator dar, den man sich als aus vielen unmittelbar benachbarten Elementarkapazitäten gebildet vorstellen muß, die über Streckenelemente der Metallplatten parallel geschaltet sind. Entsteht eine Störung auf einer potentialführenden Metallplatte, so wird sie von der unmittelbar am Entstehungsort befindlichen Elementarkapazität und ihren Nachbarn zur Massepotential führenden Metallplatte abgeleitet. Damit werden vagabundierende Störungen auf den Verbindungsleitungen zwischen den Metallplatten und der Stromversorgungseinheit wirksam unterdrückt.

Die Verbindungsrückwand 10 wird wie folgt zusammengebaut: Nicht dargestellte selbstfurchende Schrauben werden von der Außenfläche 12a der ersten Verbindungsplatine 12 her durch die Durchgangslöcher 12f gesteckt und in die Befestigungslöcher 14e der an der ersten Metallplatte 14 angeformten Lappen 14c, 14f eingeschraubt, wobei sie in diesen ein Gewinde ausformen. Die Zuordnung der Durchgangslöcher zu den entsprechenden Befestigungslöchern ist durch strichpunktierte Linien angedeutet.

Nachdem die Metallplatte 14 mit der ersten Verbindungsplatine 12 verschraubt ist, wird auf erstere eine Isolierfolie (nicht dargestellt) aufgelegt, auf diese die zweite Metallplatte 16 gelegt und in der für die erste Metallplatte beschriebenen Weise mit der ersten Verbindungsplatine 12 verschraubt. Anschließend wird die zweite Verbindungsplatine 18 in gleicher Weise auf die ihr zugekehrten Endflächen 14d, 16d der Lappen 14b und 16c geschraubt.

Eine positive weitere Wirkung neben der guten Störsicherheit der Verbindungsrückwand 10 ist darin zu sehen, daß ihr Aufbau eine Zerlegung mit einfachen Werkzeugen zuläßt. Die Verbindungsrückwand 10 zerfällt dann in ihre leicht nach Material-gruppen sortierbaren Einzelteile, da weder Löt- noch irgendwelche Klebeverbindungen getrennt werden müssen. Dies kommt der Forderung nach Recyclierbarkeit von elektronischen Anlagen entgegen.

## Patentansprüche

1. Verbindungsrückwand (10) mit auf einer Verbindungsplatine (12) angeordneten Steckvorrichtungen (20) für die Kontaktierung elektronischer und/oder elektromechanischer Einschubbaugruppen in Baugruppenträgern untereinander und mit den Potentialleitungen wenigstens einer Spannungsversorgungseinrichtung,
**gekennzeichnet durch:**
parallel und im Abstand zu der Verbindungsplatine (12) und zueinander angeordnete, diese zumindest teilweise überdeckende, jeweils ein Spannungsversorgungspotential führende Metallplatten (14, 16),
auf der Verbindungsplatine (12) aufgebrachte Kontaktflächen (12d, 12e), welche den für die Versorgungsspannungen bzw. Massepotential vorgesehenen Kontakten der Steckvorrichtungen (20) benachbart und mit diesen verbunden sind,
Verbindungselemente (14c; 16b), die die Metallplatten (14; 16) mit den für das jeweilige Potential bestimmten Kontaktflächen (12d, 12e) elektrisch und mit der Verbindungsplatine (12) mechanisch leicht wieder lösbar verbinden.

2. Verbindungsrückwand nach Anspruch 1,
**dadurch gekennzeichnet**,
daß die Verbindungselemente vorzugsweise durch Freistanzen von Lappen (14b, 14c, 14f; 16b, 16c) einstückig mit den Metallplatten (14; 16) ausgebildet sind, und daß die Lappen Z-förmig in Richtung auf die Verbindungsplatine (12) abgekröpft sind.

3. Verbindungsrückwand nach Anspruch 1 oder 2,
**dadurch gekennzeichnet**,
daß die im zusammengebauten Zustand auf den Kontaktflächen (12d, 12e) aufliegenden Endflächen (14d; 16d) der Verbindungselemente (14c; 16b) mit Befestigungslöchern (14e; 16e) und die Verbindungsplatine (12) mit mit diesen fluchtenden Durchgangslöchern (12f) versehen sind und daß die Verbindungsplatine (12) mit vorzugsweise selbstfurchenden Schrauben mit den Verbindungselementen (14c; 16c) verschraubt ist.

4. Verbindungsrückwand nach einem der Ansprüche 1 bis 3,
**dadurch gekennzeichnet**,
daß die der Verbindungsplatine (12) nahe Metallplatte (14) kleiner als die nächst weiter entfernte (16) ist und daß erstere (14) von der letzteren (16) allseits umschlossen ist, wobei die weitest entfernte Metallplatte (16) die Verbindungsplatine (12) im wesentlichen überdeckt und vorzugsweise Massepotential führt.

5. Verbindungsrückwand nach Anspruch 4,
**dadurch gekennzeichnet**,
daß wenigstens auf einem Teil der Ränder (16a) der größten Metallplatte (16) die Verbindungselemente (16b) mit einem einen zulässigen Maximalwert nicht überschreitenden gegenseitigen Abstand (A) angeordnet sind und daß die übrigen Randbereiche (24) in Richtung auf die Verbindungsplatine (12) abgewinkelt sind.

6. Verbindungsrückwand nach Anspruch 5,
**dadurch gekennzeichnet**,
daß die Potentialzuführung, z.B. Masse, zu der größten Metallplatte (16) an einem Randbereich (24) und die Potentialzuführung zu kleineren Metallplatten (14) über eine vorzugsweise einstückig an diese angeformte Anschlußfahne (14g) erfolgt, die durch eine Aussparung (28) im Randbereich (24) hindurch ragt, und daß die Potentialzuführung über Schraubverbindungen (30; 32) im Randbereich (24) bzw. in der Anschlußfahne (14g) erfolgt.

7. Verbindungsrückwand nach einem der Ansprüche 4 bis 6,
**dadurch gekennzeichnet**,
daß parallel und im Abstand zu der weitest entfernten Metallplatte (16) auf deren Rückseite eine zweite Verbindungsplatine (18) angebracht ist.

8. Verbindungsrückwand nach Anspruch 7,
**dadurch gekennzeichnet**,
daß für die Spannungsversorgung beider Verbindungsplatinen (12, 18) für jedes Potential jeweils nur eine Metallplatte (14, 16) vorgesehen ist.

9. Verbindungsrückwand nach Anspruch 7 oder 8,
**dadurch gekennzeichnet**,
daß an den Metallplatten (14; 16) weitere Lappen (14b; 16c) angeformt sind, die in Richtung auf die zweite Verbindungsplatine (18) Z-förmig abgekröpft sind.

10. Verbindungsrückwand nach Anspruch 9,
**dadurch gekennzeichnet**,
daß in den Metallplatten (16) Durchtrittsöffnungen (26) für mit anderen Metallplatten (14) verbundene Verbindungselemente (14b) vorgesehen sind, und daß die Ränder der Durchtrittsöffnungen (26) den für den jeweiligen Potentialunterschied vorgeschriebenen Mindestabstand zu den Verbindungselementen (14b) nicht unterschreiten.

11. Verbindungsrückwand nach Anspruch 9 oder 10,
**dadurch gekennzeichnet,**
daß die an den Rändern (16a) der größten Metallplatte (16) angeordneten weiteren Lappen (16c) einen einen zulässigen Maximalwert nicht überschreitenden gegenseitigen Abstand (A) haben.

12. Verbindungsrückwand nach einem der Ansprüche 5, 6, 10,11,
**dadurch gekennzeichnet**,
daß das größte Lichtmaß (D) der Durchtrittsöffnungen (26) bzw. der Abstand (A) zwischen den Verbindungselementen (16b; 16c) am Rand der größten Metallplatte (16) 1/10 bis 1/20 der Wellenlänge des höchstfrequenten Störsignals nicht überschreitet.

13. Verbindungsrückwand nach einem der Ansprüche 1 bis 12,
**dadurch gekennzeichnet,**
daß zwischen den Metallplatten (14, 16) eine Isolierfolie mit vorzugsweise hoher Dielektrizitätskonstante eingefügt ist.

## Claims

1. Connecting rear wall (10) having plug-and-socket devices (20) arranged on a connecting board (12) for making mutual contact between electronic and/or electromechanical plug-in modules in subracks, and having the potential leads of at least one power supply unit,
characterized by:
metal plates (14, 16) which are arranged parallel to and at a distance from one another and the connecting board (12) and cover the latter at least partially and respectively carry a supply voltage potential,
contact areas (12d, 12e) which are applied to the connecting board (12) and are adjacent to the contacts, provided for the supply voltages or frame potential, of the plug-and-socket devices (20) and are connected to the latter,
connecting elements (14c; 16b) which, in a fashion which is easy to disconnect again, connects the metal plates (14; 16) electrically to the contact areas (12d, 12e) specified for the respective potential and mechanically to the connecting board (12).

2. Connecting rear wall according to Claim 1, characterized in that the connecting elements are preferably constructed by stamping free lugs (14b, 14c, 14f; 16b, 16c) in one piece with the metal plates (14; 16), and in that the lugs are offset in a Z-shape fashion in the direction of the connecting board (12).

3. Connecting rear wall according to Claim 1 or 2, characterized in that the end faces (14d; 16d), bearing in the assembled state against the contact areas (12d, 12e), of the connecting elements (14c; 16b) are provided with fastening holes (14e; 16e), and the connecting board (12) is provided with through-holes (12f) aligned with said fastening holes, and in that the connecting board (12) is screwed to the connecting elements (14c; 16c) preferably by means of self-tapping screws.

4. Connecting rear wall according to one of Claims 1 to 3, characterized in that the metal plate (14) near the connecting board (12) is smaller than the next further removed (16) and the first (14) is enclosed on all sides by the latter (16), the furthest removed metal plate (16) essentially covering the connecting board (12) and preferably carrying frame potential.

5. Connecting rear wall according to Claim 4, characterized in that the connecting elements (16b) having a mutual spacing (A) not exceeding a permissible maximum value are arranged at least on one part of the edges (16a) of the largest metal plate (16), and in that the remaining edge regions (24) are bent in the direction of the connecting board (12).

6. Connecting rear wall according to Claim 5, characterized in that the potential feed, for example frame, to the largest metal plate (16) is performed at an edge region (24), and the potential feed to smaller metal plates (14) is performed via a terminal tab (14g), which is preferably integrally formed in one piece on the latter and projects through a cutout (28) in the edge region (24), and in that the potential feed is performed via screwed connections (30; 32) in the edge region (24) and in the terminal tab (14g).

7. Connecting rear wall according to one of Claims 4 to 6, characterized in that parallel to and at a spacing from the furthest removed metal plate (16) a second connecting board (18) is mounted on the rear thereof.

8. Connecting rear wall according to Claim 7, characterized in that respectively only one metal plate (14, 16) is provided for the power supply of the two connecting boards (12, 18).

9. Connecting rear wall according to Claim 7 or 8, characterized in that there are integrally formed on the metal plates (14; 16) further lugs (14b; 16c) which are offset in a Z-shaped fashion in the direction of the second connecting board (18).

10. Connecting rear wall according to Claim 9, characterized in that through openings (26) for connecting elements (14b) connected to other metal plates (14) are provided in the metal plates (16), and in that the edges of the through openings (26) do not fall below the minimum spacing from the connecting elements (14b) which is prescribed for the respective potential difference.

11. Connecting rear wall according to Claim 9 or 10, characterized in that the further lugs (16c) arranged on the edges (16a) of the largest metal plate (16) have a mutual spacing (A) which does not exceed a permissible maximum value.

12. Connecting rear wall according to one of Claims 5, 6, 10, 11, characterized in that the largest clear dimension (D) of the through openings (26) and the spacing (A) between the connecting elements (16b; 16c) on the edge of the largest metal plate (16) do not exceed 1/10 to 1/20 of the wavelength of the interference signal of highest frequency.

13. Connecting rear wall according to one of Claims 1 to 12, characterized in that an insulating foil which preferably has a high dielectric constant is inserted between the metal plates (14, 16).

## Revendications

1. Panneau arrière de connexion (10), comportant des dispositifs connecteurs (20) disposés sur une platine de connexion (12), pour mettre en contact des blocs enfichables électroniques et/ou électromécaniques entre eux dans des châssis équipés, et les lignes de potentiel d'au moins un dispositif d'alimentation en tension,
caractérisé par
des plaques métalliques (14, 16), disposées parallèlement les unes aux autres et à distance de la platine de connexion (12) et les unes des autres, recouvrant cette platine du moins en partie, et conduisant chaque fois un potentiel d'alimentation en tension,
des surfaces de contact (12d, 12e), montées sur la platine de connexion (12) voisines des contacts, prévus pour les tensions d'alimentation ou pour le potentiel de la masse, des dispositifs connecteurs (20) et reliées à eux,
des éléments de connexion (14c ; 16b), qui relient électriquement les plaques métalliques (14 ; 16) aux surfaces de contact (12d, 12e), déterminées pour le potentiel correspondant et qui les relient mécaniquement, de manière aisément détachable, à la platine de connexion (12).

2. Panneau arrière de connexion selon la revendication 1,
caractérisé par le fait que
les éléments de connexion sont, de préférence, formés d'un seul tenant avec les plaques métalliques (14 ; 16) par découpage de pattes (14b, 14c, 14f ; 16b, 16c) et que les pattes sont coudées en forme de Z en direction de la platine de connexion (12).

3. Panneau arrière de connexion selon la revendication 1 ou 2,
caractérisé par le fait que
les faces d'extrémité (14d ; 16d) des éléments de connexion (14c ; 16b) reposant, à l'état assemblé, sur les surfaces de contact (12d, 12e), sont pourvues de trous de fixation (14e ; 16e), tandis que la platine de connexion (12) est pourvue de trous traversants (12f) en alignement avec les premiers, et qu'elle est vissée aux éléments de connexion (14c ; 16c) par des vis, de préférence autotaraudeuses.

4. Panneau arrière de connexion selon l'une des revendications 1 à 3,
caractérisé par le fait que
la plaque métallique (14) proche de la platine de connexion (12) est plus petite que la suivante (16) immédiatement plus éloignée et par le fait que la première (14) est entourée de tous côtés par la dernière (16), la plaque métallique (16) située le plus loin recouvrant sensiblement la platine de connexion (12) et conduisant, de préférence, le potentiel de la masse.

5. Panneau arrière de connexion selon la revendication 4,
caractérisé par le fait que
les éléments de connexion (16b) sont disposés, au moins sur une partie des bords (16a) de la plaque métallique (16) la plus grande, avec un écartement mutuel (A) n'excédant pas une valeur maximale admissible, et par le fait que les zones de bord (24) restantes sont repliées à angle droit en direction de la platine de connexion (12).

6. Panneau arrière de connexion selon la revendication 5,
caractérisé par le fait que
l'amenée de potentiel, par exemple la masse, à la plaque métallique (16) la plus grande s'effectue au niveau d'une zone de bord (24), tandis que l'amenée de potentiel aux plaques métalliques (14) plus petites s'effectue par l'intermédiaire d'une barrette de raccordement (14g), formée de préférence d'un seul tenant avec elles et passant par un évidement (28) dans la zone de bord (24), et par le fait que l'amenée de potentiel s'effectue par l'intermédiaire d'un vissage (30 ; 32) respectivement dans la zone de bord (24) ou dans la barrette de raccordement (14g).

7. Panneau arrière de connexion selon l'une des revendications 4 à 6,
caractérisé par le fait que,
une seconde platine de connexion (18) est appliquée parallèlement à la plaque métallique (16) située le plus loin, à distance du côté arrière de celle-ci.

8. Panneau arrière de connexion selon la revendication 7,
caractérisé par le fait que,
on prévoit, pour l'alimentation en tension des deux platines de connexion (12, 18), pour chaque potentiel, chaque fois une seule plaque métallique (14, 16).

9. Panneau arrière de connexion selon la revendication 7 ou 8,
caractérisé par le fait que
d'autres pattes (14b ; 16c) sont formées sur les plaques métalliques (14 ; 16) et qu'elles sont coudées en forme de Z en direction de la seconde platine de connexion (18).

10. Panneau arrière de connexion selon la revendication 9,
caractérisé par le fait que,
on prévoit, dans les plaques métalliques (16), des ouvertures de passage (26) pour des éléments de connexion (14b) reliés à d'autres plaques métalliques (14), et par le fait que les bords des ouvertures de passage (26) ne sont pas inférieurs à la distance minimale prescrite pour la différence de potentiel correspondante, par rapport aux éléments de connexion (14b).

11. Panneau arrière de connexion selon la revendication 9 ou 10,
caractérisé par le fait que
les autres pattes (16c), disposées au niveau des bords (16a) de la plaque métallique (16) la plus grande, ont un écartement mutuel (A) qui n'excède pas une valeur maximale admissible.

12. Panneau arrière de connexion selon l'une des revendications 5, 6, 10, 11,
caractérisé par le fait que
le jour (D) le plus grand des ouvertures de passage (26) ou bien l'écartement (A) entre les éléments de connexion (16b ; 16c), au niveau du bord de la plaque métallique (16) la plus grande, n'excède pas 1/10 à 1/20 de la longueur d'onde du signal parasite à la fréquence maximale.

13. Panneau arrière de connexion selon l'une des revendications 1 à 12,
caractérisé par le fait que,
une feuille isolante, ayant de préférence une constante diélectrique élevée, est intercalée entre les plaques métalliques (14, 16).
